# EUROPÄISCHE PATENTSCHRIFT

(11) **EP 1 058 093 B1**
(45) Veröffentlichungstag und Bekanntmachung des Hinweises auf die Patenterteilung: **29.01.2003**
(21) Anmeldenummer: 99110454.8
(22) Anmeldetag: 29.05.1999
(51) Int. Cl.: G01D 3/08, G01R 31/28, G01R 19/252

(54) **Verfahren und Schaltungsanordnung zur Spannungsversorgung und Funktionsüberwachung zumindest eines Messwertumformers**
Method and circuit for powering and monitoring the functioning of at least one sensor
Procédé et circuit d'alimentation et de surveillance du fonctionnement d'au moins un convertisseur de valeurs de mesure

(43) Veröffentlichungstag der Anmeldung: 06.12.2000
(73) Patentinhaber: MTL Instruments GmbH, 44793 Bochum (DE)
(72) Erfinder: Herzog, Heinz, 44805 Bochum (DE)
(74) Vertreter: Nunnenkamp, Jörg, Dr.

(56) Entgegenhaltungen:
- DE-A- 19 629 934
- GB-A- 2 227 383

## Beschreibung

Die Erfindung betrifft ein Verfahren zur Spannungsversorgung und Funktionsüberwachung zumindest eines Meßwertumformers, insbesondere Zweileiter-Meßwertumformers in sicherheitsgefährdeten, insbesondere explosionsgefährdeten, (Industrie-)Bereichen von z. B. chemischen Anlagen. Derartige Verfahren (siehe z.B. DE-A-196 29 934) sind grundsätzlich aus der Praxis bekannt und werden je nach Fehlersicherheit verschiedenen Anwendungsklassen zugeordnet, die in der DIN V 19250 beschrieben sind. Im übrigen kommen als Beurteilungsgrundlagen für den TÜV die Normen DIN VDE 0160 (04/89) und DIN 0116 (10/89) (Abschnitt 8.7) in Frage.

Bei sogenannten Zweileiter-Meßwertumformern handelt es sich um solche Meßwertumformer (z.B. Temperatursensoren PT 100 oder Drucksensoren), die in Verbindung mit einer sogenannten Zweileiter-Schaltung zum Einsatz kommen. Eine solche Zweileiter-Schaltung erzeugt bei Anschluß an eine niederohmige Spannungsquelle einen der Meßgröße proportionalen Strom. Zu diesem Zweck ist in dem betreffenden Meßwertaufnehmer bzw. -umformer eine entsprechende Elektronik vorgesehen, für deren Versorgung ein Mindeststrom benötigt wird. Deshalb hat der Nullpunkt derartiger Systeme einen definierten Wert; vielfach liegt er bei ca. 4 mA, während das Nennsignal ca. 20 mA beträgt. Die Meßspanne entspricht also ca. 16 mA. Derartige Signalpegel sind typisch für die Prozeß- und Regeltechnik und eignen sich deshalb besonders gut für eine Überwachung und Weiterverarbeitung. Dabei lassen sich Zweileiter-Systeme bzw. -Schaltungen problemlos elektrisch miteinander verbinden.

Typische Anwendungen erfolgen in Verbindung mit Druckaufnehmern als Meßwertumformer. Selbstverständlich sind auch jegliche anderen Meßwertumformer in diesem Zusammenhang denkbar, insbesondere solche, die in sicherheits- bzw. explosionsgefährdeten Bereichen chemischer Anlagen zum Einsatz kommen und dort für eine Prozeßüberwachung sorgen. Auch Durchflußmeßgeräte werden an dieser Stelle realisiert.

Jedenfalls kommt es darauf an, den beschriebenen Zweileiter-Meßwertumformer mit einer entsprechenden Spannung bzw. einem Strom über eine Spannungsquelle zu versorgen, damit ausgangsseitig der der Meßgröße proportionale Strom zur Verfügung steht.

Die hierzu in der Praxis eingesetzten Schaltungsanordnungen bzw. Vefahrensweisen können nicht in allen Punkten überzeugen, insbesondere was das Erkennen von Schaltungs- und oder Meßwertumformer-Fehlern angeht. Hier will die Erfindung insgesamt Abhilfe schaffen.

Der Erfindung liegt das technische Problem zugrunde, ein Verfahren und eine Schaltungsanordnung zur Spannungsversorgung und Funktionsüberwachung zumindest eines Meßwertumformers anzugeben, welches bzw. welche besonders zuverlässig arbeitet und eine einwandfreie Fehlererkennung ermöglicht, so daß hiermit insbesondere Meßwertumformer betrieben werden können, die zumindest der Anwendungsklasse AK5 nach DIN V 19250 entsprechen.

Zur Lösung dieser Aufgabe ist Gegenstand der Erfindung ein Verfahren zur Spannungsversorgung und Funktionsüberwachung zumindest eines Meßwertumformers, insbesondere Zweileiter-Meßwertumformers in sicherheitsgefährdeten Bereichen von z. B. chemischen Anlagen, mit
- einer Meßwertumformschaltung mit Meßwertumformer, welche zumindest zwei meßwertabhängige, z. B. meßwertproportionale, Spannungssignale erzeugt, die in zwei korrespondierende (natürlich auch meßwertabhängige bzw. meßwertproportionale) Primärfrequenzsignale umgewandelt und an eine Überwachungs-/Auswerteschaltung mit Sicherheitssignaleinrichtung übertragen werden, und mit
- einer Spannungsquelle für die Meßwertumformschaltung und die Überwachungs-/Auswerteschaltung,
wonach die Überwachungs-/Auswerteschaltung wenigstens ein Primärfrequenzsignal in die ausgangsseitige Meßwertspannung umwandelt,
wonach ferner die Überwachungs-/Auswerteschaltung die beiden Primärfrequenzsignale wechselweise vergleicht und hierzu die beiden Primärfrequenzsignale auf Übereinstimmung oder vorgegebene Abhängigkeit überprüft, und
wonach die Sicherheitssignaleinrichtung bei Übereinstimmung oder Einhaltung der gegebenen Abhängigkeit der Primärfrequenzsignale - selbstverständlich innerhalb wählbarer Grenzen - zum Zwecke der Dokumentation eines einwandfreien Betriebes angesteuert wird oder ein Alarmsignal abgegeben wird (wenn die Übereinstimmung oder gegebene Abhängigkeit nicht vorliegt).

Zur Speisung einerseits der Meßwertumformschaltung andererseits der Überwachungs-/Auswerteschaltung ist die bereits angesprochene Spannungsquelle bevorzugt galvanisch getrennt ausgeführt. Die beiden meßwertabhängigen Primärfrequenzsignale werden in der Regel jeweils unabhängig voneinander über eine galvanische Trennvorrichtung von der Meßwertumformschschaltung an die Überwachungs-/Auswerteschaltung übertragen. Bei dieser galvanischen Trenneinrichtung kann es sich um einen Optokoppler oder übliche Transformatoren bzw. Übertrager handeln.

Regelmäßig wird lediglich eines der beiden an die Überwachungs-/Auswerteschaltung übertragenen meßwertabhängigen Primärfrequenzsignale in die Meßwertspannung umgewandelt. Um auch ausgangsseitige Fehler im Bereich der Überwachungs/Auswerteschaltung zuverlässig ausschließen zu können, sieht die Erfindung weiter vor, daß die ausgangsseitige Meßwertspannung zusätzlich in ein korrespondierendes Sekundärfrequenzsignal umgesetzt wird, welches mit den Primärfrequenzsignalen auf Übereinstimmung oder vorgegebene Abhängigkeit überprüft wird. Selbstverständlich erfolgt die vorgenannte Prüfung ebenfalls innerhalb vorwählbarer Grenzen.

Zur Ermittlung einer Fehlübertragung seitens der Meßwertumformschaltung und/oder einer Fehlfunktion der Überwachungs/Auswerteschaltung kann eine definierte Absenkung des Sekundärfrequenzsignales durchgeführt werden.

Im Ergebnis wird mit dem beschriebenen Verfahren eine zuverlässige Funktionsüberwachung eines von der Spannungsquelle gespeisten Meßwertumformers erreicht. Dies gelingt zunächst einmal durch Rückgriff auf relativ wenige Komponenten, nämlich im wesentlichen die Meßwertumformschaltung, die Überwachungs/Auswerteschaltung und schließlich die Spannungsquelle. Der aus der Praxis bekannte Stand der Technik hat es an dieser Stelle demgegenüber für unabdingbar gehalten, mindestens drei Meßwertumformschaltungen vorzusehen, aus welcher dann eine Schaltung für die Ansteuerung beispielsweise der Sicherheitssignaleinrichtung und Auswertung der Meßwertspannung herangezogen wurde. Dabei ist bei den bekannten Maßnahmen gleichsam bei einem Auftreten eines Fehlers die entsprechende Meßwertumformschaltung ausgesondert bzw. unbeachtet geblieben. Auch hat man in diesem Zusammenhang vorgeschlagen, jeweilige Mittelwerte zu bilden oder Standardabweichungen zu kontrollieren. Jedenfalls ist im Gegensatz zu diesen Maßnahmen der schaltungs- und verfahrensmäßige Aufwand im Rahmen der Erfindung deutlich reduziert. Dabei machen sich die beschriebenen Maßnahmen in Kern zunutze, daß zwei Primärfrequenzsignale in der Meßwertumformschaltung erzeugt werden, die in der Überwachungs-/Auswerteschaltung einem wechselweisen Vergleich unterzogen werden. Zu diesem Zweck stehen zwei unabhängige Rechnereinheiten in der Überwachungs-/Auswerteschaltung zur Verfügung, deren Funktionsweise und Schaltungsanordnung mit Bezug auf die Figurenbeschreibung näher erläutert wird. Folglich ist ein insgesamt redundanter Aufbau gewährleistet, so daß die erzeugten Primärfrequenzsignale unabhängig voneinander erzeugt, übertragen und verglichen werden.

Dabei registrieren diese beiden Rechnereinheiten ohne weiteres Fehler bei der Meßwertaufbereitung in der Meßwertumformschaltung. Hier macht sich die Erfindung zunutze, daß zwei meßwertabhängige, z. B. meßwertproportionale, Spannungssignale überlicherweise in einem Spannungsteiler mit zwei gleichen (Präzisions-)Widerständen erzeugt werden. Sofern hier Abweichungen der Widerstandswerte und damit der Spannungssignale auftreten, ergeben sich unmittelbare Abweichungen in den beiden korrespondierenden Primärfrequenzsignalen, die ohne weiteres beim wechselweisen Vergleich in den beiden Rechnereinheiten erfaßt werden. Selbstverständlich werden durch diese Vorgehensweise auch andere Fehler, beispielsweise von Spannungs-/Frequenzwandlern, ermittelt, die üblicherweise zur Umsetzung der meßwertabhängigen Spannungssignale in die korrespondierenden Primärfrequenzsignale eingesetzt werden. Jedenfalls läßt sich durch den Rückgriff auf die zumindest zwei meßwertabhängigen Spannungssignale und deren getrennte Aufbereitung und Übertragung an die Überwachungs-/Auswerteschaltung und den dortigen Vergleich bereits eine außerordentlich große Fehler- und Funktionssicherheit erreichen.

Diese wird noch dadurch gesteigert, daß Fehlerquellen in der Überwachungs-/Auswerteschaltung durch eine turnusgemäß durchlaufende Routine praktisch ausgeschlossen werden. Diese sieht zunächst einmal vor, daß die ausgangsseitig der Überwachungs-/Auswerteschaltung zur Verfügung stehende Meßwertspannung zusätzlich in ein korrespondierendes Sekundärfrequenzsignal umgesetzt wird. Durch Vergleich dieses Sekundärfrequenzsignales mit den beiden Primärfrequenzsignalen auf Übereinstimmung oder vorgegebene Abhängigkeit wird gleichsam die fehlerfreie Übertragung der Gesamtkette überprüft. Denn üblicherweise werden die beiden meßwertabhängigen Spannungssignale und die ausgangsseitige Meßwertspannung jeweils gleich eingestellt. Folglich liefert der vorgenannte Vergleich der beiden Primärfrequenzsignale und des Sekundärfrequenzsignales zuverlässig Aufschluß über die fehlerfreie Übertragung der vom Zweileiter-Meßwertumformer gleichsam erzeugten (meßwertabhängigen) Spannungssignale zum Ausgang (mit der dortigen Meßwertspannung).

Zur weiteren Funktionssicherheit trägt bei, daß in der Meßwertumformschaltung wiederholt eine definierte Absenkung des Sekundärfrequenzsignales durchgeführt wird, um bei der Aufbereitung und dem Vergleich der beiden Primärfrequenzsignale eventuell auftretende Fehler ausschließen zu können. Diese definierte Absenkung des Sekundärfrequenzsignales wird in der Regel von den beiden Rechnereinheiten wechselweise durchgeführt und einem Vergleich unterzogen. Sofern hier gleiche Frequenzabsenkungen detektiert werden, ist davon auszugehen,daß die Überwachungs-/Auswerteschaltung (und auch die Meßwertumformschaltung) zuverlässig funktioniert.

Die Umwandlung der meßwertabhängigen Spannungssignale in die Primärfrequenzsignale und die Umsetzung der ausgangsseitigen Meßwertspannung in das Sekundärfrequenzsignal bietet den Vorteil, daß zum einen derartige (Digital-)Frequenzsignale zuverlässig und genau in Rechnereinheiten auf Übereinstimmung oder vorgegebene Abhängigkeit überprüft werden können und zum andern eine einfache Übertragung von der Meßwertumformschaltung auf die Überwachungs-/Auswerteschaltung über die galvanische Trenneinrichtung gelingt. Der Begriff "meßwertabhängige Spannungssignale" soll im Rahmen der Erfindung ausdrücken, daß die Meßwertumformschaltung Spannungssignale erzeugt, die über eine bestimmte Abhängigkeit mit dem ermittelten Meßwert korrelieren. Hierbei kann es sich um eine quadratische Abhängigkeit handeln, was jedoch ungewöhnlich ist. Denn üblicherweise werden lineare Abhängigkeiten eingestellt, so daß meßwertproportionale Spannungssignale erzeugt werden. Dies ist - wie gesagt - jedoch nicht zwingend. Vergleichbares gilt natürlich auch bei der Umwandlung der Spannungssignale in die Primärfrequenzsignale bzw. in das Sekundärfrequenzsignal. Denn auch hier sind Abweichungen von der zumeist linearen Abhängigkeit denkbar, solange die Abhängigkeit bekannt ist und ausgewertet werden kann.

Im Ergebnis wird im Rahmen des erfindungsgemäßen Verfahrens eine praktisch lückenlose Überprüfung und Funktionsüberwachung eines Meßwertumformers gleichsam von der Meßwertaufnahme über die Umwandlung in eine meßwertabhängige Spannung weiter zur (galvanischen) Übertragung an die Überwachungs-/Auswerteschaltung und schließlich bei der Erzeugung der ausgangsseitigen Meßwertspannung zur Verfügung gestellt, so daß die beim Stand der Technik aufwendigen Ausgestaltungen und eventuelle manuelle Eingriffe ausdrücklich nicht erforderlich sind. Es wird also insgesamt eine dynamische Selbstprüfung realisiert. - Eine nach dem erfindungsgemäßen Verfahren arbeitende Schaltungsanordnung ist Gegenstand des Patentanspruches 7. Vorteilhafte Ausgestaltungen dieser Schaltungsanordnung werden in den Ansprüchen 8 ff. beschrieben.

Im folgenden wird die Erfindung anhand einer lediglich ein Ausführungsbeispiel darstellenden Zeichnung näher erläutert. Die einzige Darstellung zeigt eine Schaltungsanordnung zur Spannungsversorgung und Funktionsüberwachung zumindest eines Meßwertumformers, nach dem Ausführungsbeispiel eines Zweileiter-Meßwertumformes in sicherheitsgefährdeten Bereichen chemischer Anlagen.

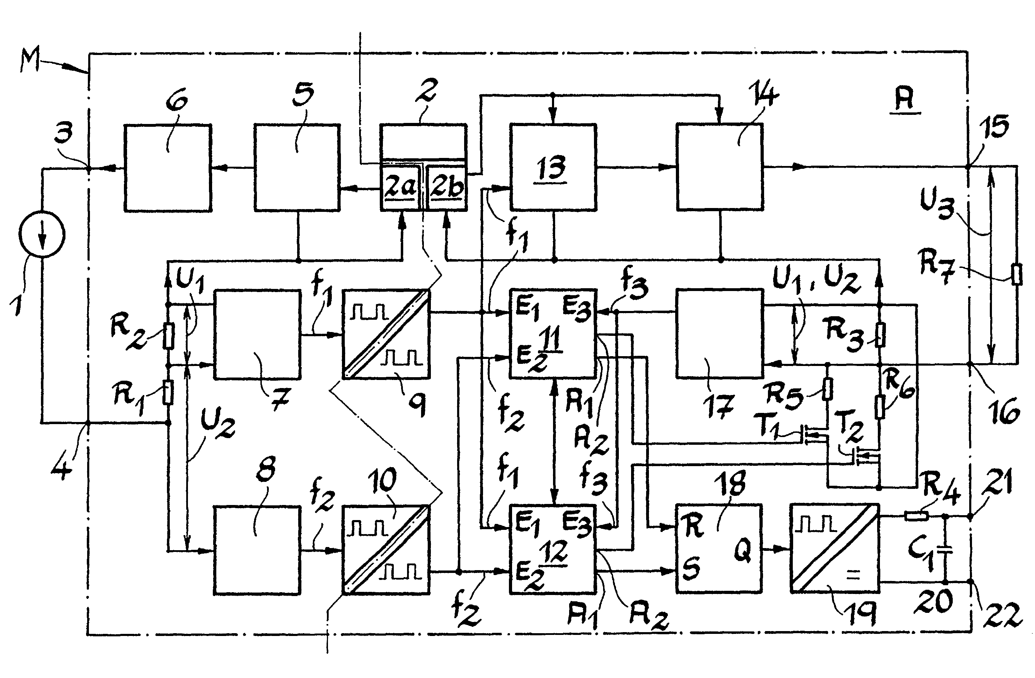

Die in der einzigen Figur dargestellte Schaltungsanordnung dient dazu, einen Zweileiter-Meßwertumformer 1 mit der erforderlichen Spannung zu versorgen und gleichzeitig eine gesamte automatische Funktionsüberwachung der Spannungsversorgung inklusive Meßwertumformer 1 zu gewährleisten. Dieser Zweileiter-Meßwertumformer 1 ist mit einer entsprechenden Elektronik ausgerüstet, die von einer Spannungsquelle 2 mit Strom versorgt wird. Ausgangsseitig des Meßwertumformers 1 steht an zugehörigen Klemmen 3, 4 ein meßwertabhängiger, vorliegend meßwertproportionaler, Strom zur Verfügung, welcher zwischen ca. 4 mA und ca 20 mA variiert. Die Meßspanne von ca. 16 mA entspricht also dem Meßbereich des Meßwertumformers 1, beispielsweise dem Druckbereich zwischen 0 MPa und 1 MPa.

Da der Meßwertumformer 1 zusammen mit einer Meßwertumformschaltung M in einem sicherheits- bzw. explosionsgefährdeten Bereich einer chemischen Anlage angeordnet ist, wie dies durch die strichpunktierte Trennlinie zur Überwachungs-/Auswerteschaltung A angedeutet wurde, befinden sich zusätzlich im Versorgungspfad zum Zweileiter-Meßwertumformer 1 ein Spannungsbegrenzer 5 und ein Strombegrenzer 6, welche dafür sorgen, daß beispielsweise beim Abreißen eines Kabels keine Funkenbildung erfolgt. Sie sind für die eigentliche Funktionsweise der erfindungsgemäßen Schaltungsanordnung von untergeordneter Bedeutung und stellen lediglich die Eigensicherheit des in dem explosionsgefährdeten Bereich über die Klemmen 3, 4 zum Meßwertumformer geführten Stromkreises sicher.

Die Spannungsquelle 2 ist galvanisch getrennt ausgeführt und dient mit einer Teilspannungsquelle 2a zur Speisung der Meßwertumformschaltung M einerseits und mit einer Teilspannungsquelle 2b zur Energieversorgung der Überwachungs-/Auswerteschaltung A andererseits, die sich in geschützten Bereichen befindet. Der Versorgungsstrom für den Meßwertumformer 1 fließt von der Teilspannungsquelle 2a über den Spannungsbegrenzer 5, den Strombegrenzer 6 die Klemme 3, den Meßwertumformer 1, die Klemme 4 schließlich zurück zur Teilspannungsquelle 2a, und zwar über die beiden Eingangswiderstände R₁ und R₂, die vorliegend als Spannungsteiler R₁, R₂ geschaltet und als gleichwertige Präzisionswiderstände ausgeführt sind. Folglich steht an beiden vorgenannten Eingangswiderständen R₁ und R₂ ein jeweils dem Meßwert proportionaler Spannungsabfall U₁ und U₂ zur Verfügung. Dieser Spannungsabfall U₁, U₂ kann so eingestellt werden, daß er über den gesamten vorstehend erläuterten Meßbereich (4 mA bis 20 mA) Werte zwischen jeweils 0,2 V bis 1 Volt einnimmt. Dementsprechend bemißt sich natürlich die Summe der Spannungsabfälle U₁ + U₂ zu 0,4V bis 2V.

Sowohl U₁ als auch U₂ werden in einem jeweils nachfolgenden Spannungs-Spannungs-/Frequenzwandler 7, 8 in korrespondierende (zum Meßwert proportionale) (Rechteck-)Frequenzen bzw. Primärfrequenzsignale f₁, f₂ umgewandelt. Diese Spannungs-/Frequenzwandler 7, 8 können gleich ausgelegt sein, wobei dann der Spannungs-/Frequenzwandler 7 die halbe Frequenz des Spannungs-/Frequenzwandlers 8 erzeugt. Dies läßt sich darauf zurückführen, daß von dem Spannungs-/Frequenzwandler 8 die gleichsam doppelt so große Spannung im Vergleich zum Spannungs-/Frequenzwandler 7 ausgewertet wird, weil der Nullpunkt der Spannung U₂ mit dem Maximalwert der Spannung U₁ zusammenfällt. So kann U₁ - wie vorstehend erläutert - Werte zwischen jeweils 0,2 V bis 1 V annehmen, während U₂ dann den Bereich von ca. 1 V bis 1,8 V oder 2 V abdeckt. Jedenfalls lassen sich hierdurch die beschriebenen Frequenzverhältnisse erklären.

Aufgrund der Tatsache, daß der Spannungs-/Frequenzwandler 7 die halbe Frequenz des Spannungs-/Frequenzwandlers 8 erzeugt, muß eine entsprechende Anpassung in zwei Rechnereinheiten 11, 12 bzw. Mikroprozessoren stattfinden. Dies kann dergestalt erfolgen, daß beispielsweise die im Spannungs-/Frequenzwandler 7 erzeugte Frequenz f₁ mit dem Faktor 2 oder die ausgangsseitig des Spannungs-/Frequenzwandlers 8 anstehende Frequenz f₂ mit dem Faktor 0,5 bewertet wird, bevor die nachfolgend noch beschriebene Differenzwertbildung erfolgt. Alternativ hierzu kann aber auch die Steilheit des Spannungs-/Frequenzwandlers 8 auf die Hälfte der Steilheit des Spannungs-/Frequenzwandlers 7 eingestellt werden. Für diesen Fall lassen sich idealerweise ausgangsseitig (Rechteck-)Frequenzen f_{1,} f₂ gleicher Frequenz (und gleicher Amplitude) erzeugen. - Bei den Spannungs-/Frequenzwandlern 7, 8 mag es sich um spannungsgesteuerte Oszillatoren (Voltage Controlled Oscillator, VCO) handeln.

An die beiden vorgenannten Spannungs-/Frequenzwandler 7, 8 sind jeweils galvanische Trenneinrichtungen 9, 10 angeschlossen, welche für die unabhängige Übertragung der solchermaßen erzeugten Primärfrequenzsignale f₁, f₂ von der. Meßwertumformschaltung M zur Überwachungs-/Auswerteschaltung A sorgen. Bei diesen galvanischen Trenneinrichtungen 9, 10 kann es sich um Optokoppler oder Übertrager handeln, die jedenfalls zu keiner Beeinflussung der jeweils übertragenen Frequenz f₁, f₂ korrespondieren. Durch die galvanische Trennung an dieser Stelle und im Bereich der Spannungsquelle 2 ist eine völlige Unabhängigkeit von einerseits Meßwertumformschaltung M und andererseits Überwachungs-/Auswerteschaltung A gewährleistet, sowohl was die Speisung bzw. Energieversorgung angeht als auch die Signalübertragung.

Im Anschluß an die galvanischen Trenneinrichtungen 9, 10 werden die (Rechteck-)Frequenzen f₁, f₂ in den zwei Rechnereinheiten 11, 12 bzw. Mikroprozessoren ausgewertet. Dies geschieht im einzelnen dergestalt, daß die von der galvanischen Trenneinrichtung 9 übermittelte Frequenz f₁ sowohl an einen Eingang E₁ der Rechnereinheit 11 als auch an einen Eingang E₁ Rechnereinheit 12 übertragen wird. Gleiches gilt für die mittels der Trenneinrichtung 10 aufgenommene zweite Frequenz f₂, die über entsprechende Eingänge E₂ in der Rechnereinheit 11 und in der Rechnereinheit 12 eingelesen wird.

Darüber hinaus wird die mittels der galvanischen Trenneinrichtung 9 übertragene Frequenz f₁ in einem Frequenz-/Spannungswandler 13 und schließlich einem Spannungs/Stromwandler 14 in einen (idealerweise) dem Eingangsstrom an den Klemmen 3, 4 entsprechenden Ausgangsstrom bzw. eine Meßwertspannung U₃ (in Verbindung mit einem Widerstand R₇) an Klemmen 15, 16 umgewandelt. Der solchermaßen zur Verfügung gestellte Meßwertstrom an den Klemmen 15, 16 wird in einem dritten Spannungs-/Frequenzwandler 17 (welcher neben den bereits beschriebenen Wandlern 7, 8 vorgesehen ist) in eine (Rechteck-)Frequenz umgewandelt. Zu diesem Zweck ist ein Festwiderstand bzw. Widerstand R₃ vorgesehen, welcher R₁ bzw. R₂ entspricht, so daß von dem Spannungs-/Frequenzwandler 17 vergleichbare Spannungsabfälle U₁, U₂ umgesetzt werden. Da der Spannungs-/Frequenzwandler 17 im wesentlichen mit den korrespondierenden Bauelementen 7, 8 deckungsgleich ist, entspricht die von diesem abgegebene (Rechteck-)Frequenz f₃ den eingangsseitig der Rechnereinheiten 11, 12 eingelesenen Primärfrequenzsignalen f₁, f₂. Dieses sogenannte Sekundärfrequenzsignal f₃ ausgangsseitig des Spannungs-Frequenzwandlers 17 wird über Eingänge E₃ in der Rechnereinheit 11 bzw. 12 eingelesen.

Dabei wird im einzelnen so vorgegangen, daß die Gleichheit der Frequenzen f₁, f₂, f₃ an den jeweiligen Eingängen E₁, E₂ und E₃ in jeder Rechnereinheit 11, 12 unabhängig voneinander ermittelt wird. Dies wird im Detail so durchgeführt, daß die beiden Rechnereinheiten 11, 12 nach einem sogenannten Master-/Slave-Konzept arbeiten. Stellt z. B. die Rechnereinheit 11 eine Übereinstimmung der Frequenzen f₁, f₂, f₃ an seinen Eingängen E₁ bis E₃ fest, so wird über den dortigen Ausgang A1 ein RS-Flip-Flop 18 und dort dessen R-Eingang gesetzt.

Im Anschluß hieran erfolgt die gleiche Prüfung in der Rechnereinheit 12, die bei Übereinstimmung an ihren Eingängen E₁ bis E₃ über den dortigen Ausgang A₁ den korrespondierenden S-Eingang des RS-Flip-Flops 18 setzt. Die Mikroprozessoren bzw. Rechnereinheiten 11, 12 tauschen danach wieder ihre Funktionen, so daß eine wechselweise Kontrolle und ein wechselweises Takten der Eingänge R und S des RS-Flip-Flops 18 erfolgt.

Dieses üblicherweise aus zwei NOR-Gattern aufgebaute RS-Flip-Flop 18 nimmt in bekannter Weise nur bei wechselnder Beaufschlagung des jeweiligen Eingangs R oder S einen entsprechenden wechselnden Zustand an seinem Ausgang Q ein. Mit anderen Worten liegt nur bei wechselweiser erfolgreicher Prüfung auf Übereinstimmung der Frequenzen f₁, f₂, f₃ seitens der Rechnereinheit 11 wie der Rechnereinheit 12 am Ausgang Q des RS-Flip-Flops 18 eine (Rechteck-)Spannung an. Diese Reckteckspannung wird über eine weitere galvanische Trenneinrichtung 19 an eine Sicherheitssignaleinrichtung 20 übertragen und gleichgerichtet. Ausgangsseitig dieser Sicherheitssignaleinrichtung 20 ist ein Siebglied aus einem Widerstand R₄ und einem Kondensator C₁ vorgesehen, so daß an zugehörigen Klemmen 21, 22 eine Gleichspannung anliegt. Diese Gleichspannung signalisiert die Übereinstimmung der Frequenzen f₁, f₂, f₃, da nur bei entsprechend getaktetem RS-Flip-Flop 18 auch eine korrespondierende Gleichspannung erzeugt wird.

Sobald ein Fehler auftritt, wird der Ausgang Q des RS-Flip-Flops 18 nicht mehr getaktet, weil dann entsprechende Eingangssignale fehlen. Dies führt dazu, daß die Gleichspannung an den Klemmen 21, 22 zusammenbricht und folglich ein Alarmsignal ausgesendet werden kann oder das Signal zur Dokumentation eines einwandfreien Betriebes ausfällt. Ein solcher Fehler kann beispielsweise darin liegen, daß der Widerstand R₂ eine Temperaturdrift aufweist und angenommen einen größeren Widerstand als R₁ einnimmt. Dies führt zu einem vergrößerten Spannungsabfall U₁ gegenüber U₂, so daß die zugehörigen Spannungs-/Frequenzwandler 7, 8 unterschiedliche Frequenzen f₁, f₂ erzeugen, die dann in den Rechnereinheiten 11, 12 zu einer Fehlermeldung beim Vergleich führen. Selbstverständlich sind in den Rechnereinheiten 11, 12 entsprechende Fehlergrenzen bzw. Variationen für die Übereinstimmung der Frequenzen f₁, f₂ eingebbar, und zwar wählbar.

Fehler im Bereich der Übertragungs-/Auswerteschaltung A lassen sich durch eine sogenannte Fehlersimulation ausschalten, die nachfolgend beschrieben wird. Um sicherzustellen, daß die Rechnereinheiten 11, 12 im Falle einer Fehlübertragung diese auch erkennen, wird mittels dieser Fehlersimulation fortlaufend durch Parallelschalten von Zuschaltwiderständen bzw. Widerständen R₅ und R₆ zu R₃ eine Frequenzabsenkung des am jeweiligen Eingang E₃ anliegenden Sekundärfrequenzsignales f₃ erreicht. Dies geschieht dergestalt, daß die Rechnereinheiten 11, 12 über jeweilige Ausgänge A₂ wechselweise den Widerständen R₅ und R₆ jeweils vorgeschaltete Feldeffekttransistoren T₁ und T₂ auf Durchlaß schalten, so daß einerseits der Widerstand R₅ parallel zum Widerstand R₃, andererseits der Widerstand R₆ parallel zum Widerstand R₃ liegt. Folglich sinkt der Strom durch R₃ und damit auch der mittels des Spannungs-/Frequenzwandlers 17 in die entsprechende (Rechteck-)Frequenz f₃ umgewandelte Spannungsabfall U₁, U₂. Gleichzeitig fällt die Frequenz des Sekundärfrequenzsignales f₃ am jeweiligen Eingang E₃ der Rechnereinheit 11 bzw. 12. Dieser Frequenzabfall des Sekundärfrequenzsignals f₃ im Vergleich zu den Primärfrequenzsignalen f₁, f₂ wird in der jeweiligen Rechnereinheit 11, 12 überprüft. Kommen beide Prozessoren bzw. Rechnereinheiten 11, 12 zu einem übereinstimmenden Ergebnis, dann - und nur dann - darf z. B. der R-Eingang des RS-Flip-Flops 18 bedient werden.

Auch in diesem Fall wird das sogenannte Master-/Slave-Konzept verfolgt. Dabei mag die Rechnereinheit 11 beginnen und beispielsweise die Fehlersimulation erkennen. Im nächsten Zyklus wird dann die Rechnereinheit 12 aufgefordert, die Fehlersimulation durchzuführen. Sind beide Fehlerermittlungen gleich, dann ist der andere Prozessor - in diesem Fall die Rechnereinheit 12 - berechtigt, beispielsweise den S-Eingang des RS-Flip-Flops 18 zu bedienen. Dies geschieht selbstverständlich wechselweise, wie die Überprüfung der Primärfrequenzsignale f₁, f₂. Folglich wird auch beim erfolgreichen Durchlaufen der vorbeschriebenen Fehlersimulationsroutine das RS-Flip-Flop 18 wechselweise getaktet, so daß an den Ausgängen 21, 22 das die einwandfreie Funktionsweise dokumentierende Gleichspannungssignal anliegt.

Im Rahmen einer weiteren Programmroutine werden die Primärfrequenzsignale f₁, f₂ und das Senkundärfrequenzsignal f₃ innerhalb eines vorgegebenen Toleranzbandes auf Gleichheit geprüft, wobei ebenfalls eine gegenseitige Kontrolle der Prozessoren 11, 12 stattfindet. Auch hier werden die zugehörigen Ausgänge A₁ nur dann bedient, wenn Übereinstimmung besteht.

Im Ergebnis werden hierdurch zuverlässig sowohl Fehlfunktionen der Meßwertumformschaltung 11 als auch Fehlfunktionen der Überwachungs-/Auswerteschaltung A abgedeckt, wenn beispielsweise der Widerstand R₃ oder irgendeine Leitung einen Fehler aufweist. Selbstverständlich wird durch die beschriebenen Routinen auch der Ausfall eines Prozessors bzw. einer Rechnereinheit 11, 12 sofort erfaßt und führt - wie sämtliche übrigen Fehler - dazu, daß das RS-Flip-Flop 18 nicht mehr in der erforderlichen Art und Weise getaktet wird, so daß die Gleichspannung an den Klemmen 21, 22 zusammenbricht. Selbstverständlich wird auch ein Ausfall der galvanischen Trenneinrichtung 9, 10 der Widerstände R₁, R₂, R₄ oder des Kondensators C₁ erfaßt. Dies gilt auch für den Fall, daß die Spannungsquelle 2 nicht (mehr) zuverlässig arbeitet.

Im Ergebnis wird hierdurch sichergestellt, daß die Primärfrequenzsignale f₁, f₂ und das Sekundärfrequenzsignal f₃ innerhalb des gleichsam zulässigen und durch die Zweileiter-Schaltung vorgegebenen Bereiches liegen, folglich ausgangsseitig Signalwerte für den Strom durch den Meßwertumformer 1 von ca. 3,6 mA und 21 mA als Grenzwerte festgelegt werden. Selbstverständlich lassen sich auch andere Grenzwerte programmieren. - Für den Fall, daß die Frequenzen f₁, f₂, f₃ außerhalb der solchermaßen festgelegten Grenzen liegen, wird ebenfalls die Taktung des RS-Flip-Flop 18 unterbrochen, weil dann zugehörige und in die Rechnereinheiten 11, 12 eingegebene Grenzwerte überschritten werden, die zu entsprechenden Signalen an den Ausgängen A₁ korrespondieren.

## Patentansprüche

1. Verfahren zur Spannungsversorgung und Funktionsüberwachung zumindest eines Meßwertumformers (1), insbesondere Zweileiter-Meßwertumformers (1) in sicherheitsgefährdeten Bereichen von z. B. chemischen Anlagen, mit
- einer Meßwertumformschaltung (M), welche zumindest zwei meßwertabhängige Spannungssignale (U₁, U₂) erzeugt, die in zwei korrespondierende Primärfrequenzsignale (f₁, f₂) umgewandelt und an eine Überwachungs-/Auswerteschaltung (A) mit Sicherheitssignaleinrichtung (20) übertragen werden, und mit
- einer Spannungsquelle (2) für die Meßwertumformschaltung (M) und die Überwachungs-/Auswerteschaltung (A) ,
wonach die Überwachungs-/Auswerteschaltung (A) wenigstens ein Primärfrequenzsignal (f₁, f₂) in eine ausgangsseitige Meßwertspannung (U₃) umwandelt,
wonach ferner die Überwachungs-/Auswerteschaltung (A) die beiden Primärfrequenzsignale (f₁, f₂) wechselweise vergleicht und hierzu die beiden Primärfrequenzsignale (f₁, f₂) auf Übereinstimmung oder vorgegebener Abhängigkeit überprüft, und
wonach die Sicherheitssignaleinrichtung (20) bei Übereinstimmung oder Einhaltung der gegebenen Abhängigkeit zum Zwecke der Dokumentation eines einwandfreien Betriebes angesteuert wird.

2. Verfahren nach Anspruch 1, **dadurch gekennzeichnet, daß** zur Speisung einerseits der Meßwertumformschaltung (M) andererseits der Überwachungs-/Auswerteschaltung (A) die Spannungswelle (2) galvanisch getrennt ausgeführt wird.

3. Verfahren nach Anspruch 1 oder 2, **dadurch gekennzeichnet, daß** die beiden Primärfrequenzsignale (f₁, f₂) jeweils unabhängig voneinander über eine galvanische Trenneinrichtung (9, 10) von der Meßwertumformschaltung (M) an die Überwachungs-/Auswerteschaltung (A) übertragen werden.

4. Verfahren nach einem der Ansprüche 1 bis 3, **dadurch gekennzeichnet, daß** lediglich eines der beiden an die Überwachungs-/Auswerteschaltung (A) übertragenen Primärfrequenzsignale (f₁) in die Meßwertspannung (U₃) umgewandelt wird.

5. Verfahren nach einem der Ansprüche 1 bis 4, **dadurch gekennzeichnet, daß** die Meßwertspannung (U₃) zusätzlich in ein korrespondierendes Senkundärfrequenzsignal (f₃) umgesetzt wird, welches mit den Primärfrequenzsignalen (f₁, f₂) auf Übereinstimmung oder vorgegebene Abhängigkeit überprüft wird.

6. Verfahren nach einem der Ansprüche 1 bis 5, **dadurch gekennzeichnet, daß** zur Ermittlung einer Fehlübertragung seitens der Meßwertumformschaltung (M) und/oder einer Fehlfunktion der Überwachungs-/Auswerteschaltung (A) eine definierte Absenkung des Sekundärfrequenzsignales (f₃) durchgeführt wird.

7. Schaltungsanordnung zur Durchführung des Verfahrens nach einem der Ansprüche 1 bis 6, mit
- einer galvanisch getrennten Spannungsquelle (2) zur unabhängigen Speisung einerseits der Meßwertumformschaltung (M) andererseits der Überwachungsauswerteschaltung (A), wobei
- die Meßwertumformschaltung (M) zumindest den Meßwertumformer (1), einen Spannungsteiler (R₁, R₂) zur Erzeugung der wenigstens zwei meßwertabhängigen Spannungssignale (U₁, U₂) und wenigstens zwei Spannungs-/Frequenzwandler (7, 8) zur Umsetzung der beiden meßwertabhängigen Spannungssignale (U₁, U₂) in zwei korrespondierende Primärfrequenzsignale (f₁, f₂) aufweist, wobei ferner
- die Überwachungs-/Auswerteschaltung (A) mit zumindest zwei Rechnereinheiten (11, 12) zum jeweils wechselweisen Vergleich der beiden Primärfrequenzsignale (f₁, f₂) sowie einer von beiden Rechnereinheiten (11, 12) gesteuerten Sicherheitssignaleinrichtung (20) ausgerüstet ist und einen Frequenz-Spannungswandler (13) zur Umsetzung des oder der Primär-Frequenzsignale (f₁, f₂) in die ausgangsseitige Meßwertspannung (U₃) aufweist, und wobei
- eine galvanische Trenneinrichtung (9, 10) jeweils zwischen Meßwertumformschaltung (M) und Überwachungs-/Auswerteschaltung (A) zur Übertragung der Primärfrequenzsignale (f₁, f₂) vorgesehen ist.

8. Schaltungsanordnung nach Anspruch 7, **dadurch gekennzeichnet, daß** die beiden Rechnereinheiten (11, 12) in Abhängigkeit von der Prüfung der beiden Primärfrequenzsignale (f₁, f₂) jeweils einen Eingang einer Kippschaltung, z. B. RS-Flip-Flop (18), zur vorzugsweisen Erzeugung einer Gleichspannung im Zuge der Dokumentation des einwandfreien Betriebes mittels der Sicherheitssignaleinrichtung (20) ansteuern.

9. Schaltungsanordnung nach Anspruch 7 oder 8, **dadurch gekennzeichnet, daß** zusätzlich ein dritter Spannungs-/Frequenzwandler (17) in der Überwachungs-/Auswerteschaltung (A) vorgesehen ist, welcher ausgangsseitig das Senkundärfrequenzsignal (f₃) erzeugt, welches in den beiden Rechnereinheiten (11, 12) auf Übereinstimmung mit den Primärfrequenzsignalen (f₁, f₂) überprüft wird.

10. Schaltungsanordnung nach einem der Ansprüche 7 bis 9, **dadurch gekennzeichnet, daß** zur Fehlersimulation und Absenkung der Frequenz des Sekundärfrequenzsignales (f₃) von den Rechnereinheiten (11, 12) beaufschlagbare Schalteinrichtungen, z. B. Feldeffekttransistoren (T₁, T₂) vorgesehen sind, welche jeweils Zuschaltwiderstände (R₅, R₆) einem Festwiderstand (R₃) parallel schalten, der für den zur Erzeugung des Senkundärfrequenzsignales (f₃) mit Hilfe des dritten Spannungs-Frequenzwandlers (17) erforderlichen Spannungsabfall sorgt.

## Claims

1. A method for voltage supply and monitoring at least of one digital transformer (1), in particular a dual-core digital transformer (1), placed in areas of chemical plants for example where safety is compromised, having
- a digital converter circuit (M), which generates at least two digital-dependent voltage signals (U₁, U₂), which are converted into two corresponding primary frequency signals (f₁, f₂) and are transmitted to a monitoring/evaluation circuit (A) with a safety signal mechanism (20), and having
- a voltage source (2) for the digital converter circuit (M) and the monitoring/evaluation circuit (A) ,
according to which the monitoring/evaluation circuit (A) converts at least one primary frequency signal (f₁, f₂) into output-side digital voltage (U₃),
according to which also the monitoring/evaluation circuit (A) alternately compares both the primary frequency signals (f₁, f₂) and to this end tests both the primary frequency signals (f₁, f₂) for matching or preset dependency, and
according to which the safety signal mechanism (20) is controlled by matching or complying with the preset dependency for the purpose of documenting trouble-free operation.

2. The method as claimed in Claim 1, **characterised in that** the voltage wave (2) is configured galvanically separate for supplying the digital converter circuit (M) on the one hand and the monitoring/evaluation circuit (A) on the other hand.

3. The method as claimed in Claim 1 or 2, **characterised in that** both primary frequency signals (f₁, f₂) are in each case transmitted independently of one another by means of a galvanic dividing device (9, 10) from the digital converter circuit (M) to the monitoring/evaluation circuit (A).

4. The method as claimed in any one of Claims 1 to 3, **characterised in that** only one of the two primary frequency signals (f₁) transmitted to the monitoring/evaluation circuit (A) is converted into digital voltage (U₃).

5. The method as claimed in any one of Claims 1 to 4, **characterised in that** the digital voltage (U₃) is additionally converted into a corresponding secondary frequency signal (f₃), which is checked with the primary frequency signals (f₁, f₂) for matching or preset dependency.

6. The method as claimed in any one of Claims 1 to 5, **characterised in that** a defined drop in the secondary frequency signal (f₃) is executed to determine error transmission on the part of the digital converter circuit (M) and/or error function of the monitoring/evaluation circuit (A).

7. A circuit arrangement for carrying out the method as claimed in any one of Claims 1 to 6, having
- a galvanically separate voltage source (2) for independent supply of the digital converter circuit (M) on the one hand and of the monitoring/evaluation circuit (A) on the other hand, whereby
- the digital converter circuit (M) has at least the digital converter (1), a voltage divider (R₁, R₂) for generating the at least two digital-dependent voltage signals (U₁, U₂) and at least two voltage/frequency converters (7, 8) for converting both digital-dependent voltage signals (U₁, U₂) into two corresponding primary frequency signals (f₁, f₂), whereby also
- the monitoring/evaluation circuit (A) is equipped with at least two computer units (11, 12) in each case for alternate comparison of both primary frequency signals (f₁, f₂) as well as a safety signal mechanism (20) controlled by both computer units (11, 12) and has a frequency voltage converter (13) for converting the primary frequency signal or signals (f₁, f₂) into the output-side digital voltage (U₃), and whereby
- a galvanic dividing device (9, 10) is in each case provided between the digital converter circuit (M) and the monitoring/evaluation circuit (A) for transmitting the primary frequency signals (f₁,f₂).

8. The circuit arrangement as claimed in Claim 7, **characterised in that**, depending on the checking of both primary frequency signals (f₁, f₂), both computer units (11, 12) in each case control input of a trigger circuit, an RS flip-flop (18) for example, to preferably generate a direct voltage in the course of documenting trouble-free operation by means of the safety signal mechanism (20).

9. The circuit arrangement as claimed in Claim 7 or 8, **characterised in that** a third voltage/frequency converter (17) is additionally provided in the monitoring/evaluation circuit (A), which generates the output-side secondary frequency signal (f₃) which is checked in both computer units (11, 12) for matching with the primary frequency signals (f₁, f₂).

10. The circuit arrangement as claimed in any one of Claims 7 to 9, **characterised in that** provided for error simulation and lowering the frequency of the secondary frequency signal (f₃) from the computer units (11, 12) are supplyable switchgears, e.g. field effect transistors (T₁, T₂), which in each case switch connecting resistors (R₅, R₆) parallel to a fixed resistor (R₃) which provides the voltage drop required to generate the secondary frequency signal (f₃) by means of the third voltage frequency converter (17).

## Revendications

1. Procédé pour l'alimentation en tension électrique et la supervision fonctionnelle d'au moins un convertisseur de valeurs de mesure (1), notamment d'un convertisseur de valeurs de mesure à deux conducteurs (1) dans les secteurs où la sécurité est mise en péril, par exemple dans des installations chimiques, incluant
- un circuit de conversion de valeurs de mesure (M), qui émet au moins deux signaux de tension (U₁, U₂) dépendant des valeurs de mesure, qui sont convertis en deux signaux de fréquence primaire (f₁, f₂) correspondants et sont transmis à un circuit de supervision/exploitation (A) comportant un dispositif à signaux de sécurité (20), et
- une source de tension (2) pour le circuit de conversion de valeurs de mesure (M) et le circuit de supervision/exploitation (A),
après quoi le circuit de supervision/exploitation (A) convertit au moins un signal de fréquence primaire (f₁, f₂) en une tension de valeur de mesure (U₃) côté sortie,
après quoi de plus le circuit de supervision/exploitation (A) compare alternativement les deux signaux de fréquence primaire (f₁, f₂) et vérifie pour cela les deux signaux de fréquence primaire (f₁, f₂) au niveau de leur concordance ou de leur dépendance prédéfinie, et
après quoi le dispositif à signaux de sécurité (20), en cas de concordance ou respect de la dépendance définie, est activé aux fins d'attester un fonctionnement parfait.

2. Procédé selon la revendication 1, **caractérisé en ce que** l'onde de tension (2) est d'un type séparé au niveau galvanique afin d'alimenter d'une part le circuit de conversion de valeurs de mesure (M), d'autre part le circuit de supervision/exploitation (A) .

3. Procédé selon la revendication 1 ou 2, **caractérisé en ce que** les deux signaux de fréquence primaire (f₁, f₂) sont transmis respectivement indépendamment l'un de l'autre par l'intermédiaire d'un dispositif de séparation galvanique (9, 10) du circuit de conversion de valeurs de mesures (M) au circuit de supervision/exploitation (A).

4. Procédé selon une des revendications 1 à 3, **caractérisé en ce que** seulement un des deux signaux de fréquence primaire (f₁) transmis au circuit de supervision/exploitation (A) est converti en tension de valeurs de mesure (U₃).

5. Procédé selon une des revendications 1 à 4, **caractérisé en ce que** la tension de valeurs de mesure (U₃) est de plus convertie en un signal de fréquence secondaire correspondant (f₃), qui est contrôlé au niveau de sa concordance ou dépendance prédéfinie avec les signaux de fréquence primaire (f₁, f₂).

6. Procédé selon une des revendications 1 à 5, **caractérisé en ce que**, aux fins de détecter un défaut de transmission au niveau du circuit de conversion de valeurs de mesure (M) et/ou un fonctionnement défectueux du circuit de supervision/exploitation (A), on procède à une réduction définie du signal de fréquence secondaire (f₃).

7. Agencement de circuits pour la réalisation du procédé selon une des revendications 1 à 6, comportant
- une source de tension (2) séparée au niveau galvanique pour l'alimentation indépendante d'une part du circuit de conversion de valeurs de mesure (M), d'autre part du circuit de supervision/exploitation (A),
- le circuit de conversion de valeurs de mesure (M) comportant au moins le convertisseur de valeurs de mesure (1), un diviseur de tension (R₁, R₂) pour la production des au moins deux signaux de tension (U₁, U₂) dépendant des valeurs de mesure et au moins deux transformateurs de tension/fréquence (7, 8) pour la conversion des deux signaux de tension (U₁, U₂) dépendant des valeurs de mesure en deux signaux de fréquence primaire (f₁, f₂) correspondants,
- le circuit de supervision/exploitation (A) étant équipé en outre d'au moins deux unités numériques (11, 12) pour la comparaison respectivement alternative des deux signaux de fréquence primaire (f₁, f₂) ainsi que d'un dispositif à signaux de sécurité (20) commandé par les deux unités numériques (11, 12) et un transformateur de fréquence-tension (13) pour la conversion du ou des signaux de fréquence primaire (f₁, f₂) en tension de valeurs de mesure (U₃) côté sortie, et
- un dispositif de séparation galvanique (9, 10) étant respectivement prévu entre le circuit de conversion de valeurs de mesure (M) et le circuit de supervision/exploitation (A) pour la transmission des signaux de fréquence primaire (f₁, f₂).

8. Agencement de circuits selon la revendication 7, **caractérisé en ce que** les deux unités numériques (11, 12) commandent en fonction du contrôle des deux signaux de fréquence primaire (f₁, f₂) respectivement une entrée d'un circuit bistable, par ex. RS-Flip-Flop (18), pour produire de préférence une tension continue au cours de l'attestation de fonctionnement parfait au moyen du dispositif à signaux de sécurité (20).

9. Agencement de circuits selon la revendication 7 ou 8, **caractérisé en ce que** dans le circuit de supervision/exploitation (A) un troisième transformateur de tension/fréquence (17) est en plus prévu, qui émet côté sortie le signal de fréquence secondaire (f₃), lequel est contrôlé dans les deux unités numériques (11, 12) au niveau de sa concordance avec les signaux de fréquence primaire (f₁, f₂).

10. Agencement de circuits selon une des revendications 7 à 9, **caractérisé en ce que**, pour la simulation d'erreurs et la réduction de la fréquence du signal de fréquence secondaire (f₃), des dispositifs d'activation pouvant être sollicités par les unités numériques (11, 12), par exemple des transistors à effet de champ (T₁, T₂), sont prévus, qui activent respectivement des résistances d'actionnement (R₅, R₆) parallèlement à une résistance fixe (R₃) qui assure la chute de tension nécessaire à l'émission du signal de fréquence secondaire (f₃) avec l'aide du troisième transformateur de tension-fréquence (17).
